# EUROPEAN PATENT APPLICATION

(11) **EP 2 378 662 A1**
(43) Date of publication of application: **19.10.2011**
(21) Application number: 11152035.9
(22) Date of filing: 25.01.2011
(51) Int. Cl.: H03G 11/02

(54) **Limiter**

(30) Priority: 16.04.2010 JP 2010095115
(71) Applicant: Kabushiki Kaisha Toshiba, Minato-ku Tokyo (JP)
(72) Inventor: Satomi, Akihiro, Tokyo (JP)
(74) Representative: Joly, Jean-Jacques

(57) **Abstract**

According to one embodiment, a limiter includes: a first capacitor and a second capacitor serially connected which are being placed between an input terminal and an output terminal; a semiconductor device connected to a connecting point of the first capacitor and the second capacitor, and to the ground, which becomes conductive when the input terminal receives the high-frequency high-power pulse signal; a choke coil, a first end thereof connected to the connecting point of the first capacitor and the second capacitor; a high-frequency coupler connected to the input terminal; a high-frequency detecting unit connected to the high-frequency coupler to detect the high-frequency high-power pulse signal which is inputted to the input terminal; and a bias applying unit configured to apply a reverse bias voltage to a second end of the choke coil when the high-frequency high-power pulse signal is detected by the high-frequency detecting unit.

## Description

### FIELD

The embodiments described herein relate to a limiter for protecting an amplifying circuit when high-frequency high-power pulse signals are inputted thereinto.

### BACKGROUND

A radar apparatus acquires an image of an object within a certain coverage by: transmitting high-frequency high-power pulse signals; and receiving waves which are reflected back from the object. The receiving unit including an amplifier needs to be protected from high-power pulse signals which are transmitted and from high-power pulse signals which are strongly reflected back from a short-distant object.

To this end, a limiter for limiting the input of the high-power pulse signals into the receiving unit is used as a protecting circuit. As is often the case, PIN diodes are used in the limiter used in the radar apparatus, because the PIN diodes are small in size, low in price, and easily disposable.

As a PIN diode in the first stage of the limiter, a diode with a large chip size which is capable of reducing thermal resistance is used for the purpose of making such a PIN diode withstand the high power. The PIN diode has a P-I-N junction which has an intrinsic semiconductor layer ("I" layer) in the center of the PN junction. The PIN diode is a high-frequency resistance element for changing high-frequency series resistance by controlling a forward electric current which flows in the junction.

the layer of the PIN diode is thick, the PIN diode does not break down even when the electric power of 2 to 3 kW is applied to the PIN diode. For this reason, the PIN diode exhibits an excellent performance as the limiter. On the other hand, the PIN diode which does not break down even when the electric power of 2 to 3 kW is applied thereto has the thick I layer, and its recovery time is accordingly as long as several milliseconds. The PIN diode makes the receiving unit unable to receive signals for a long length of time after transmission pulses are transmitted out, and reduces the short-distance performance of the radar apparatus.

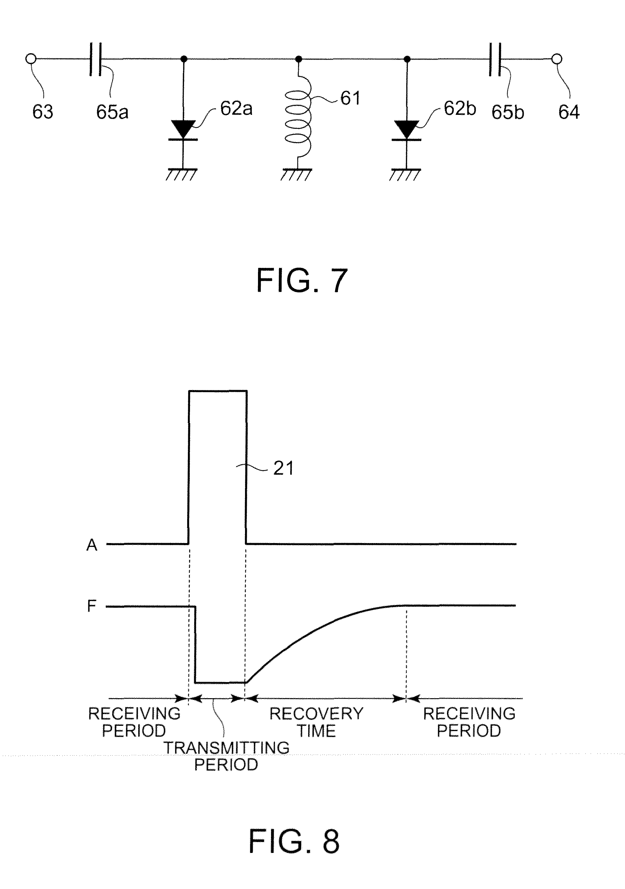

Fig. 7 shows an example of a circuit of a conventional limiter using PIN diodes. This limiter includes PIN diodes 62a, 62b which are connected to a grounded choke coil 61. The PIN diodes 62a, 62b are placed on the respective sides of the choke coil 61. In addition, the limiter includes: a capacitor 65a connected to an input terminal 63 and the PIN diode 62a; and a capacitor 65b connected to an output terminal 64 and the PIN diode 62b.

When a low-power high-frequency signal is inputted into the input terminal 63, the high-frequency signal is outputted, as it is, from the output terminal 64. A waveform A in Fig. 8 shows a waveform of a voltage in the input terminal 63. When a high-power high-frequency signal 21 is inputted into the input terminal 63, a forward voltage is applied to the PIN diode 62a in the first stage by the high-power high-frequency signal 21, and the PIN diode 62a thus turns into a conductive state. Thereby, no high-power high-frequency signal is outputted from the output terminal 64.

Once the high-power high-frequency signal 21 is eliminated, charges stored in the I layer escape to the earth through the choke coil 61. The amount of charges stored in the I layer are illustrated as a waveform F in Fig. 8. As the I layer is made thicker for the purpose of increasing the breakdown voltage, the amount of charges stored in the I layer becomes larger. This increases a length of time needed for a depletion layer to be formed due to the depletion of charges. This length of time is termed as a recovery time. For this length of time, no high-frequency signal is transmitted from the input terminal 63 to the output terminal 64, and the radar apparatus is accordingly capable of detecting no signal. As the recovery time becomes longer, the short-distance range over which the radar apparatus is incapable of performing surveillance becomes wider. This reduces the performance of the radar apparatus.

JP, PH06-21739A discloses a diode limiter for applying a forward bias voltage to a PIN diode. This limiter decreases a leakage power which occurs when a high-power signal is inputted thereinto. In addition, JP, P2008-22232A discloses a limiter circuit with a high-frequency characteristic and a limiting characteristic improved by nullifying the inductance component of a PIN diode with a circuit.

### BRIEF DESCRIPTION OF THE DRAWINGS

Fig. 1 is a circuit diagram showing a configuration of a limiter according to a first embodiment.
Fig. 2 is a waveform diagram for explaining operations according to the first embodiment.
Fig. 3 is a circuit diagram showing a configuration of a limiter according to a second embodiment.
Fig. 4 is a circuit diagram showing a configuration of a limiter according to a third embodiment.
Fig. 5 is a circuit diagram showing a configuration of a limiter according to a fourth embodiment.
Fig. 6 is a circuit diagram showing a configuration of a limiter according to a fifth embodiment.
Fig. 7 is a circuit diagram showing an example of a configuration of a conventional limiter.
Fig. 8 is a waveform diagram for explaining operations of the conventional limiter shown in Fig. 7.

### DETAILED DESCRIPTION

According to one embodiment, a limiter includes an input terminal, an output terminal, a first capacitor, a first semiconductor device, a choke coil, a second capacitor, a high-frequency coupler, a high-frequency detecting unit and a bias applying unit. The first capacitor has a first end and a second end, the first end is connected to the input terminal. The first semiconductor device has a first end and a second end, the first end is connected to the second end of the first capacitor, and the second end is grounded. The first semiconductor device is configured to become conductive when the input terminal receives a high-frequency high-power pulse signal. The choke coil has a first end and a second end, the first end is connected to a connecting point between the first end of the first semiconductor device and the second end of the first capacitor. The second capacitor has a first end and a second end, the first end is connected to a connecting point between the first end of the choke coil and the first end of the first semiconductor device, and the second end is connected to the output terminal. The high-frequency coupler is connected to the input terminal. The high-frequency detecting unit is connected to the high-frequency coupler and is configured to output a detection signal when detecting the high-frequency high-power pulse signal which is inputted into the input terminal. The bias applying unit is configured to apply a reverse bias voltage for the first semiconductor device to the second end of the choke coil based on the detection signal outputted by the high-frequency detecting unit.

### (First Embodiment)

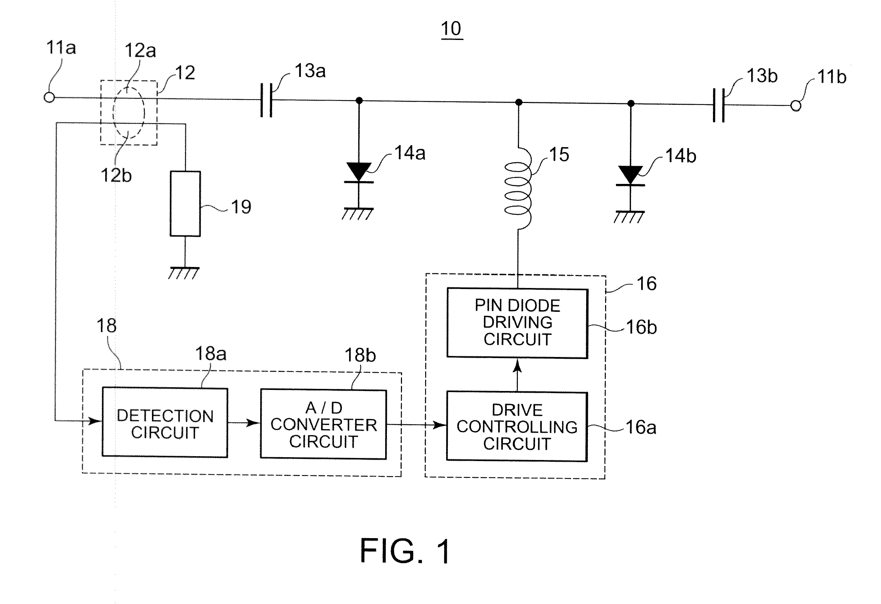

Descriptions will be hereinbelow provided for a limiter according to a first embodiment by use of the drawings. Fig. 1 shows a circuit of the limiter according to the first embodiment.

A limiter 10 includes an input terminal 11a, an output terminal 11b, a high-frequency coupler 12, a first capacitor 13a, a first PIN diode 14a, a choke coil 15, a second PIN diode 14b, a second capacitor 13b, a termination resistor 19, a high-frequency detecting unit 18, and a bias applying unit 16.

The high-frequency coupler 12 is connected to the input terminal 11a. A first end of the first capacitor 13a is connected to the input terminal 11a via the high-frequency coupler 12. A second end of the first capacitor 13a is connected to an anode terminal of the first PIN diode 14a. A cathode terminal of the first PIN capacitor 14a is grounded. A first end of the choke coil 15 is connected to the anode terminal of the first PIN diode 14a. A second end of the choke coil 15 is connected to the bias applying unit 16. An anode terminal of the second PIN diode 14b is connected to a connecting point between the anode terminal of the first PIN diode 14a and the first end of the choke coil 15. A cathode terminal of the second PIN diode 14b is grounded. A first end of the second capacitor 13b is connected to the anode terminal of the second PIN diode 14b. A second end of the second capacitor 13b is connected to the output terminal 11b.

The high-frequency coupler 12 includes: a first path 12a for transmitting a high-frequency signal, which is inputted into the input terminal 11a, to the first capacitor 13a; and a second path 12b, coupled to the first path, for transmitting the high-frequency signal to the high-frequency detecting unit 18. A first end of the second path 12b is connected to the high-frequency detecting unit 18. A second end of the second path 12b is connected to a first end of the termination resistor 19a for consuming an electric power. A second end of the termination resistor 19 is grounded. The high-frequency detecting unit 18 includes a detection circuit 18a and an A/D converter circuit 18b. The detection circuit 18a detects the high-frequency signal which is inputted into the input terminal 11a, and thus outputs a detection signal. The A/D converter circuit 18b converts the detection signal from analog to digital, and thus outputs a resultant detection signal.

The bias applying unit 16 includes a drive controlling circuit 16a and a PIN diode driving circuit 16b. The PIN diode driving circuit 16b applies a reverse bias voltage for driving the PIN diodes 14a, 14b to the choke coil 15, and thus applies the reverse bias voltage to the PIN diodes 14a, 14b via the choke coil 15. In this embodiment, a negative voltage is applied to the anode terminals of the respective PIN diodes 14a, 14b. The drive controlling circuit 16a generates a drive controlling signal for controlling the PIN diode driving circuit 16b based on the output signal from the A/D converter circuit 18b.

An antenna is connected to the input terminal 11a of the limiter 10, and a receiver is connected to the output terminal 11b of the limiter 10.

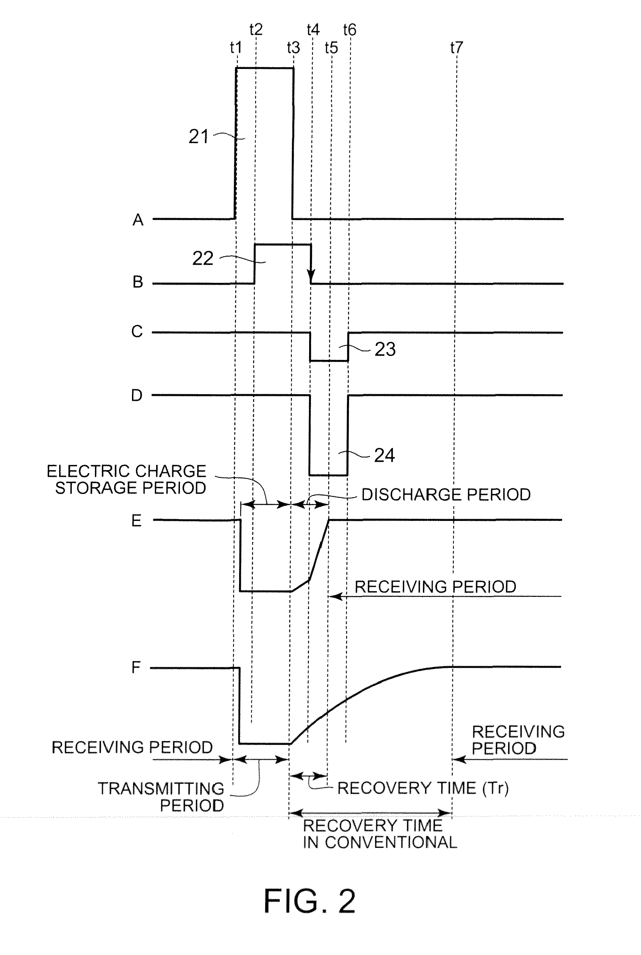

Next, referring to Fig. 2, descriptions will be provided for operations according to the embodiment. A waveform A shows a waveform of a voltage in the input terminal 11a. A waveform B shows a waveform of the output signal in the output terminal of the high-frequency detecting unit 18. A waveform C shows a waveform of the drive controlling signal in the output terminal of the drive controlling circuit 16a. A waveform D shown a waveform of a PIN diode driving signal in the output terminal of the PIN diode driving circuit 16b. A waveform E shows the amount of charges stored in the I layer of a PIN diode. In addition, a waveform F shows the amount of charges stored in the I layer of a PIN diode in a conventional apparatus, and is shown as a comparative example.

When a high-voltage, high-frequency high-power pulse signal 21 comes into the input terminal 11a from time t1 through time t3, a spike leakage power occurs in the output terminal 11b via the capacitors 13a, 13b before the PIN diode 14a responds to the pulse signal 21. The high-frequency high-power pulse signal 21 is inputted into the high-frequency detecting unit 18 via the high-frequency coupler 12. The detection circuit 18a detects the inputted high-power pulse signal 21, and outputs a detection signal. The A/D converter circuit 18b converts the detection signal from analog to digital, and outputs a pulse 22 as a resultant detection signal. Specifically, in response to the high-power pulse signal 21, the high-frequency detecting unit 18 outputs the pulse 22, whose rise and fall times are respectively times t2, t4, as the detection signal.

The drive controlling circuit 16a is triggered by the fall of the pulse 22 outputted from the high-frequency detecting unit 18, and thus generates a negative pulse 23 which has a predetermined width from time t4 through time t6. This pulse 23 is inputted into the PIN diode driving circuit 16b. The PIN diode driving circuit 16b generates the reverse bias voltage by converting the pulse 23 to a high-voltage negative pulse 24 which is a PIN diode driving pulse, and thus applies the reverse bias voltage to the PIN diodes 14a, 14b via the choke coil 15. It is desirable that the pulse 24 outputted from the PIN diode driving circuit 16b should have a a width which is several microseconds, and a voltage value which is approximately -10 V to approximately -100 V.

Consequently, the disappearance of charges from the I layer of each PIN diodes 14a, 14b between time t3 and time t4 proceeds as in the conventional case. For this reason, the PIN diodes 14a, 14b trace a regular recovery curve during this period.

At time t4, however, the high-voltage negative pulse 24 shown as the waveform D is applied to the anode terminals of the respective PIN diodes 14a, 14b. Thereby, the disappearance of the charges from the I layer of each of the PIN diodes 14a, 14b is accelerated. As shown by the waveform E, the disappearance of the charges is completed, for example, at time t5 preceding time t6. Until time t5, the forward bias is being applied to each PIN diode, and the PIN diode remains in the ON state, that is, in the conductive state. For this reason, the limiter does not transmit the signal, which is inputted into the input terminal 11a, to the output terminal 11b until time 5. On and after time t5, each PIN diode turns in an OFF state, that is, in a nonconductive state. Thereby the limiter transmits the signal, which is inputted into the input terminal 11a, to the output terminal 11b.

Accordingly, the recovery time (Tr) which starts immediately after the transmission of the high-power pulse signal 2 is completed, and which continues until the receivable state returns, start at time t3 and ends at time t5. In this respect, the width of the negative pulse 23 outputted from the drive controlling circuit 16a (i.e., the length of time from time t4 through time t6) is important. It is desirable that this length of time should be longer than the length of time needed for the charges to disappear from the I layer of each PIN diode. In general, this length of time may be approximately several microseconds.

As clear from the comparison between the waveform E and the waveform F, this embodiment makes it possible to make the recovery time shorter than the recovery time (the length of time from time t3 through time t7) of the conventional apparatus.

With regard to the foregoing embodiment, the descriptions have been provided for the diode limiter provided with the PIN diodes 14a, 14b on the respective input and output sides of the choke coil 15. When the high-power pulse signal is inputted into this limiter, the limiter is capable of fully protecting a receiving circuit, which is connected posteriorly to the limiter, by putting not only the first PIN diode 14a but also the second PIN diode 14b into the conductive state.

### (Second Embodiment)

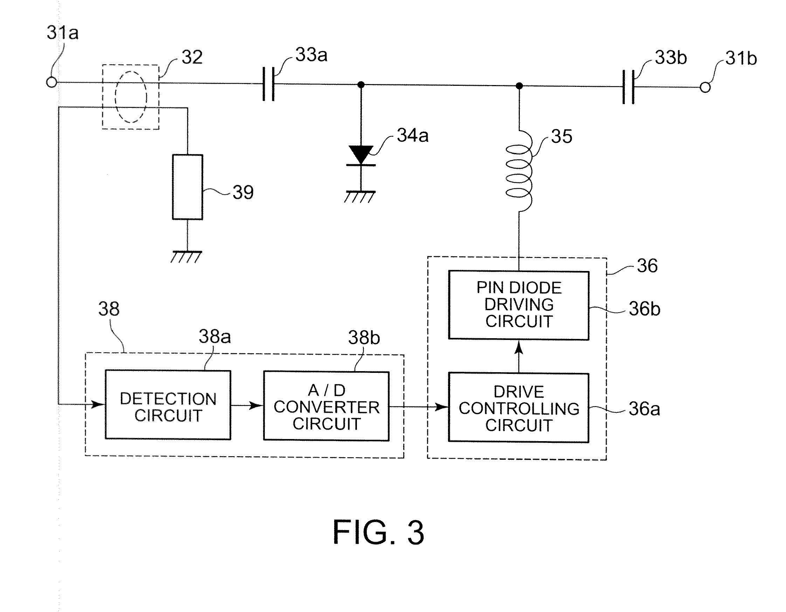

Even if the limiter includes no second PIN diode 14b, the limiter is capable of protecting the posterior receiving circuit. Fig. 3 shows a limiter according to a second embodiment, which includes one PIN diode.

Reference numerals 31a to 39 in Fig. 3 correspond to reference numerals 11a to 19 in Fig. 1. Note that the limiter shown in Fig. 3 includes only a PIN diode 34a which corresponds to the first PIN diode 14a in Fig. 1, but no PIN diode which corresponds to the second PIN diode 14b in Fig. 1. In other words, the limiter according to the second embodiment is a limiter obtained by eliminating the second PIN diode from the limiter according to the first embodiment. For this reason, detailed descriptions will be omitted for the configuration of the limiter according to this embodiment.

When a high-power pulse signal is inputted into the input terminal 31a, turns the PIN diode 34a turns into the conductive state, and accordingly this diode limiter also protects a posterior receiving circuit connected to the output terminal 31b.

A high-power signal pulse inputted into the input terminal 31a is transmitted to the high-frequency coupler 32, and is subsequently inputted into the high-frequency detecting unit 38 via the high-frequency coupler 32. The high-frequency detecting unit 38 detects the high-power signal pulse, and outputs a pulse, which corresponds to the high-power signal pulse, as a detection signal. The pulse of the detection signal outputted from the high-frequency detecting unit 38 is inputted into the drive controlling circuit 36a. At a timing of the fall of the pulse, the drive controlling circuit 36a generates a negative pulse. The PIN diode driving circuit 36b converts the negative pulse to a negative high-voltage PIN diode driving pulse, and applies the PIN diode driving pulse to the choke coil 35. Thereby, a reverse bias voltage is applied to the PIN diode 34a, and the charges disappear from the I layer rapidly. Once the disappearance of the charges from the I layer is completed, the reverse bias voltage turns the PIN diode into an OFF state, that is, in a nonconductive state.

Like the limiter according to the first embodiment, the limiter according to this embodiment enables the charges, which are stored in the I layer of the PIN diode 34a, to disappear rapidly, and is accordingly capable of reducing the recovery time.

### (Third Embodiment)

The limiter shown in Fig. 1 includes one PIN diode 14b posterior to the choke coil 15. Instead, the limiter may include multiple PIN diodes, which are connected together in parallel, posterior to the choke coil 15.

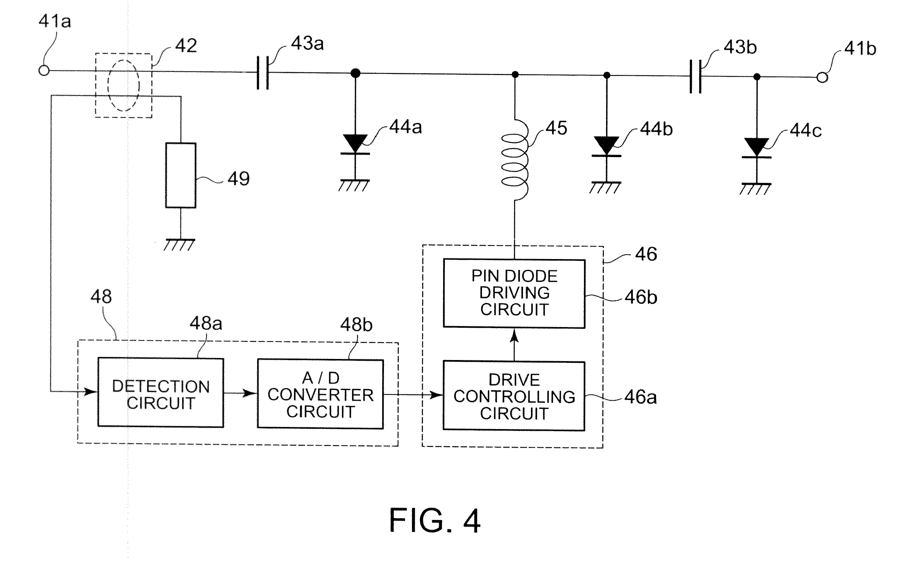

Fig. 4 shows a configuration of a limiter according to a third embodiment. In this embodiment, the limiter includes two PIN diodes posterior to the choke coil.

Reference numerals 41a to 49 in Fig. 4 correspond to reference numerals 11a to 19 in Fig. 1. It is noted that the limiter shown in Fig. 4 includes a third PIN diode 44c, which is placed between an end of a second capacitor 43b and the grounded electrode, in addition to the configuration of the limiter shown in Fig. 1. The limiter according to the third embodiment has the same basic configuration as the limiter according to the first embodiment. For this reason, detailed descriptions will be omitted for the configuration of the limiter according to the third embodiment.

A high-power signal pulse inputted into the input terminal 41a is transmitted to the high-frequency coupler 42, and is subsequently inputted into the high-frequency detecting unit 48 via the high-frequency coupler 42. The high-frequency detecting unit 48 detects the high-power signal pulse, and outputs a pulse, which corresponds to the high-power signal pulse, as a detection signal. The pulse of the detection signal outputted from the high-frequency detecting unit 48 is inputted into the drive controlling circuit 46a. At a timing of the fall of the pulse, the drive controlling circuit 46a generates a negative pulse. The PIN diode driving circuit 46b converts the negative pulse to a negative high-voltage PIN diode driving pulse, and applies the PIN diode driving pulse to the choke coil 45. Thereby, a reverse bias voltage is applied to the PIN diodes 44a and 44b, and the charges disappear from the I layer rapidly respectively. Once the disappearance of the charges from the I layers is completed, the reverse bias voltage turns the PIN diodes an OFF state, that is, in a nonconductive state.

The limiter according to this embodiment enables the charges, which are stored in the I layers of the PIN diodes 44a and 44b, to disappear rapidly, and is accordingly capable of reducing the recovery time.

In this embodiment, two PIN diodes 44b, 44c are provided in parallel with the choke coil on the output side in addition to a first PIN diode 44a on the input side. Once a high-power signal pulse is inputted, these PIN diodes 44b, 44c turn into the conductive state as well. Thereby, it is possible to inhibit the leakage of the high-power pulse to an output terminal 41b. This embodiment is more advantageous than the first embodiment, because this embodiment is capable of protecting a posterior receiving circuit connected to the output terminal 41b more fully.

### (Fourth Embodiment)

The foregoing embodiments use the PIN diodes as the elements for, upon reception of a high-power pulse signal, inhibiting the passing of the signal by turning into the conductive state. Nevertheless, elements which turn into the conductive state between their terminals are not limited to the PIN diodes. The limiter may use semiconductor devices other than these PIN diodes. Next, descriptions will be provided for a fourth embodiment of such a kind.

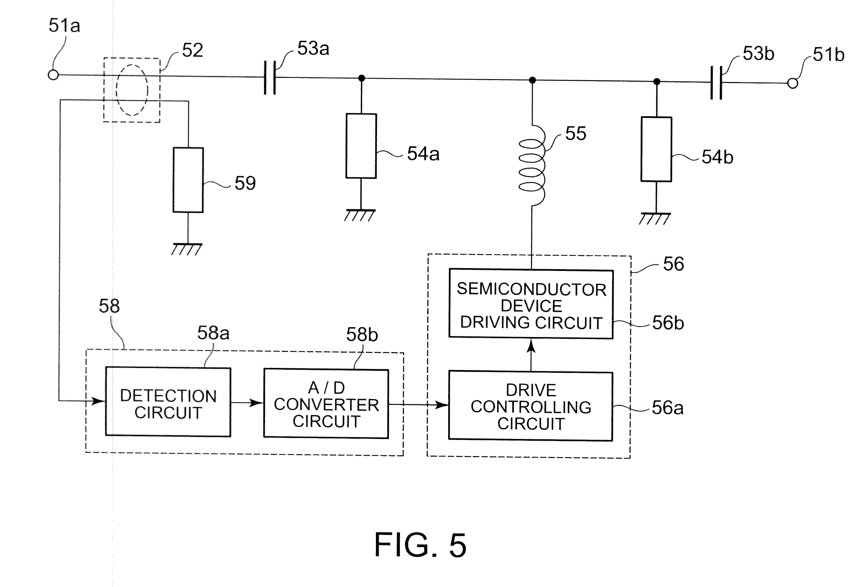

Fig. 5 shows a configuration of a limiter according to this embodiment. The limiter according to this embodiment is a limiter obtained by replacing the first and second PIN diodes 14a, 14b in the configuration shown in Fig. 1 with first and second semiconductor devices 54a, 54b, respectively. Schottky barrier diodes (SBDs) are used as the semiconductor devices. Reference numerals 51a to 59 in Fig. 5, except for reference numerals 54a, 54b and a semiconductor device driving circuit 56b, correspond to reference numerals 11a to 19 in Fig. 1. For this reason, detailed descriptions will be omitted for the configuration of this embodiment.

The semiconductor devices 54a, 54b are devices each of which becomes conductive between its two terminals when a high-power signal is applied to the terminals. Note that a drive controlling circuit 56a and the semiconductor device driving circuit 56b constitute a bias applying unit 56 for applying a reverse bias voltage.

A high-power signal pulse inputted into the input terminal 51a is transmitted to the high-frequency coupler 52, and is subsequently inputted into the high-frequency detecting unit 58 via the high-frequency coupler 42. The high-frequency detecting unit 58 detects the high-power signal pulse, and outputs a pulse, which corresponds to the high-power signal pulse, as a detection signal. The pulse of the detection signal outputted from the high-frequency detecting unit 58 is inputted into the drive controlling circuit 56a. At a timing of the fall of the pulse, the drive controlling circuit 56a generates a negative pulse. The semiconductor device driving circuit 56b converts the negative pulse to a negative high-voltage semiconductor device driving pulse, and applies the semiconductor device driving pulse to the first semiconductor device 54a and the second semiconductor device 54b via the choke coil 55. Thereby, a reverse bias voltage is applied to the first semiconductor device 54a and the second semiconductor device 54b.

The limiter according to this embodiment enables the charges, which are stored in the semiconductor devices to disappear rapidly, and is accordingly capable of reducing the recovery time.

In the case where the semiconductor devices other than the PIN diodes are used, the number of semiconductor devices may be changed as in the case of the limiters shown in Figs. 3 and 4. In other words, the limiter may use one semiconductor device as in the case of the limiter shown in Fig. 3. Otherwise, the limiter may include two or more semiconductor devices which are connected posteriorly to the choke coil as in the case of the limiter shown in Fig. 4. The latter limiter is capable of inhibiting the transmission of the high-power pulse signal to the output terminal to a large extent. For this reason, the latter limiter enhances the effect of protecting the receiving circuit connected to the latter stage of the limiter more.

### (Fifth Embodiment)

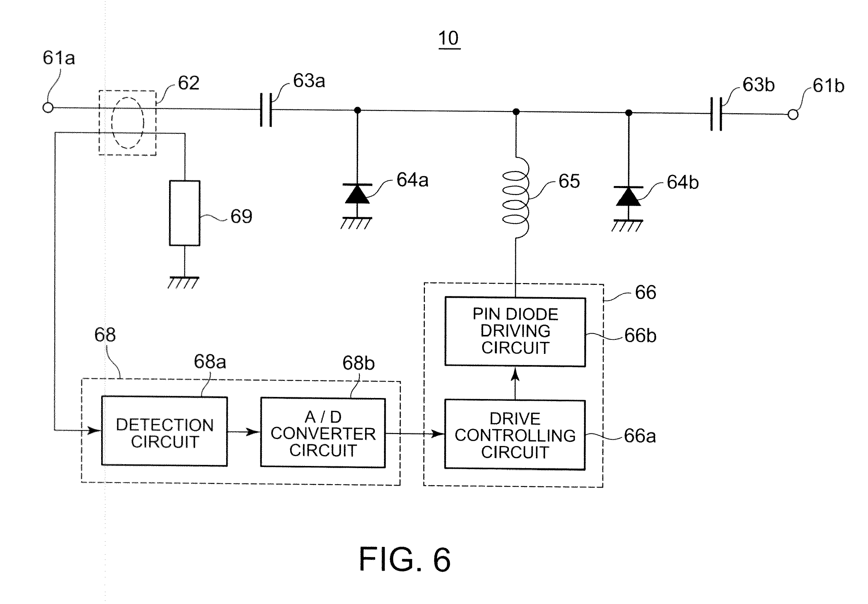

In the limiters according to the first to third embodiments, the cathode terminal of each PIN diode is grounded. Instead, the anode terminal of each PIN diode may be grounded. Fig. 6 shows a diagram of a circuit of a limiter according to a fifth embodiment. This limiter is different from the limiter according to the first embodiment in that: the anode terminals of PIN diodes 64a, 64b are grounded; and the cathode terminals thereof are connected to an end of a choke coil 65. A PIN diode driving circuit 66b generates a positive high-voltage PIN diode deriving pulse for the purpose of applying a reverse bias voltage to the PIN diodes 64a, 64b. Subsequently, the PIN diode driving circuit 66b applies the positive high-voltage PIN diode driving pulse to the other end of the choke coil 65.

The limiter according to this embodiment makes it possible to make the charges, which are stored in the I layer of each of the PIN diodes 64a, 64b, disappear rapidly, and is accordingly capable of reducing the recovery time.

The foregoing embodiments provide the respective limiters each capable of reducing the recovery time. A radar apparatus using any of these limiters enhances its short-distance performance.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A limiter comprising:
an input terminal;
an output terminal;
a first capacitor having a first end and a second end, the first end connected to the input terminal;
a first semiconductor device having a first end and a second end, the first end connected to the second end of the first capacitor, the second end grounded, the first semiconductor device configured to become conductive when the input terminal receives a high-frequency high-power pulse signal;
a choke coil having a first end and a second end, the first end connected to a connecting point between the first end of the first semiconductor device and the second end of the first capacitor;
a second capacitor having a first end and a second end, the first end connected to a connecting point between the first end of the choke coil and the first end of the first semiconductor device, the second end connected to the output terminal;
a high-frequency coupler connected to the input terminal;
a high-frequency detecting unit connected to the high-frequency coupler and configured to output a detection signal when detecting the high-frequency high-power pulse signal which is inputted into the input terminal; and
a bias applying unit configured to apply a reverse bias voltage for the first semiconductor device to the second end of the choke coil based on the detection signal outputted by the high-frequency detecting unit.

2. The limiter according to claim1, wherein the first semiconductor device is a first PIN diode.

3. The limiter according to claim 2, wherein the first PIN diode has an anode terminal connected to the second terminal of the first capacitor and a cathode terminal connected to the ground.

4. The limiter according to claim 2, wherein the first PIN diode has a cathode terminal connected to the second terminal of the first capacitor and an anode terminal connected to the ground.

5. The limiter according to claim 1, further includes a second semiconductor device having a first end connected to a connecting point between the first end of the choke coil and the first end of the second capacitor, and a second end connected to the ground.

6. The limiter according to the claim5, wherein the first semiconductor device is a first PIN diode and the second semiconductor device is a second PIN diode.

7. The limiter according to claim 6, wherein
the first PIN diode has an anode terminal connected to the second end of the first capacitor and a cathode terminal connected to the ground, and
the second PIN diode has an anode terminal connected to the first end of the second capacitor and a cathode terminal connected to the ground.

8. The limiter according to claim 6, wherein
the first PIN diode has a cathode terminal connected to the second end of the first capacitor and an anode terminal connected to the ground, and
the second PIN diode has a cathode terminal connected to the first end of the second capacitor and an anode terminal connected to the ground.

9. The limiter according to claim 5, further includes a third PIN diode having a first end connected to the output terminal and a second end connected to the ground.

10. The limiter according to claim 1, wherein the first semiconductor device is a Schottky barrier diode.

11. The limiter according to claim 5, wherein the first semiconductor device is a first Schottky barrier diode and the second semiconductor device is a second Schottky barrier diode

12. The limiter according to claim 1, wherein the first end of the first capacitor is connected to the input terminal via the high-frequency coupler.

13. The limiter according to claim 1, wherein the high-frequency detecting unit has a detection circuit to detect the high-frequency high-power pulse which is inputted into the input terminal and to output a detection signal, and an A/D converter to convert the detection signal from the detection circuit from analog to digital and to output a resultant detection signal.

14. The limiter according to claim 2, wherein the bias applying unit has a drive controlling circuit to generate a drive controlling signal based on the detection signal outputted from the high-frequency detection unit and a PIN diode driving circuit to generate the reverse bias voltage based on the drive controlling signal.
